# EUROPEAN PATENT APPLICATION

(11) **EP 4 730 925 A2**
(43) Date of publication of application: **22.04.2026**
(21) Application number: 25200002.1
(22) Date of filing: 03.09.2025
(51) Int. Cl.: H05K 1/14, H05K 1/189, H01M 10/42

(54) **CIRCUIT BOARD ASSEMBLY AND RECHARGEABLE BATTERY INCLUDING THE SAME**

(30) Priority: 16.10.2024 KR 20240141470
(71) Applicant: SAMSUNG SDI CO., LTD., Yongin-si, Gyeonggi-do 17084 (KR)
(72) Inventor: KIM, Youngbok, 17084 Yongin-si (KR)
(74) Representative: Marks & Clerk LLP

(57) **Abstract**

A circuit board assembly according to an embodiment of the present disclosure includes an integrated module including a first printed circuit board having a first surface and a second surface opposite to the first surface, a plurality of first pads on the first surface, and a plurality of electronic components on the second surface, and a second printed circuit board including a main line portion, the second printed circuit board receiving the first surface of the first printed circuit board and covering the plurality of first pads, and a connector extending from one side of the main line portion, wherein the first printed circuit board and the second printed circuit board are electrically connected.

## Description

### BACKGROUND

### 1. Field

The present disclosure relates to a circuit board assembly and a rechargeable battery including the same.

### 2. Description of the Related Art

In general, a primary battery is not designed to be recharged, but a rechargeable battery is designed to be charged and discharged. Low-capacity rechargeable batteries are used in portable small-sized electronic devices such as a smartphone, a feature phone, a notebook computer, a digital camera, a camcorder, and the like, and high-capacity rechargeable batteries are extensively used as a power source and a power storage device for driving a motor for a hybrid vehicle and an electric vehicle.

The rechargeable battery may include a flexible printed circuit board (FPCB) that is electrically connected to each battery cell to measure information of the battery cell (e.g., voltage and current information) and transmit the information to an external device.

The flexible printed circuit board may be connected to a variety of electronic components. Additionally, the flexible printed circuit board may be connected to a printed circuit board (PCB) on which various electronic components are disposed or placed. The printed circuit board may be a rigid printed circuit board that is more rigid than the flexible printed circuit board.

The connection between the flexible printed circuit board and the printed circuit board is usually made by connecting one end of the flexible printed circuit board to one end of the printed circuit board. In this case, the volume of the circuit board assembly formed by integrating the printed circuit board and the flexible printed circuit board may increase because the length of each circuit board must be considered.

On the other hand, as demand for high-capacity rechargeable batteries gradually increases, the capacity of battery cells accommodated in battery packs may also increase. The size of the battery cells may be increased to provide the higher capacity. The increased size may not be desirable as it may increase the overall volume of the battery pack.

In some cases, assuming that the battery pack has a limited volume to meet the specifications, as the size of the battery cell increases, the space for accommodating other electronic components inside the battery pack decreases. For example, if a protection module that ensures the stability of a rechargeable battery is not installed due to insufficient space in the battery pack, this may lead to stability problems not only for the battery pack but also for devices that use the battery pack as a power source (e.g., smartphones, wearable devices, etc.).

Accordingly, there is a need for a method to reduce the volume of electronic components when configuring rechargeable batteries.

The above information disclosed in this Background section is for enhancement of understanding of the background of the present disclosure, and therefore, it may contain information that does not constitute the related (or prior)art.

### SUMMARY

One or more embodiments of the present disclosure are directed to reducing the volume of a circuit board assembly for a rechargeable battery and improving soldering accuracy and soldering strength between components of the circuit board assembly.

Technical solutions obtainable from the present disclosure are not limited to the above-mentioned technical solutions. Further, other unmentioned technical solutions can be clearly understood from the following description by those having ordinary skill in the technical field to which the present disclosure pertains.

A circuit board assembly according to an embodiment of the present disclosure includes an integrated module including a first printed circuit board having a first surface and a second surface opposite to the first surface, a plurality of first pads on the first surface, and a plurality of electronic components on the second surface, and a second printed circuit board including a main line portion, the second printed circuit board receiving the first surface of the first printed circuit board and covering the plurality of first pads, and a connector extending from one side of the main line portion, wherein the first printed circuit board and the second printed circuit board are electrically connected.

The second printed circuit board may further include a plurality of connection pads on one surface of the main line portion and arranged corresponding to the arrangement of the first pads.

A connection pad of the plurality of connection pads may have a larger area than other connection pads of the plurality of connection pads, wherein the connection pad is adjacent to the connector.

The connection pad adjacent to the connector may have a recessed portion recessed in a width direction of the second printed circuit board on at least one side.

A first pad of the plurality of first pads may have a larger area than other first pads of the plurality of first pads, wherein the first pad is adjacent to the connector.

The first pad adjacent to the connector may have a recessed portion recessed in a width direction of the first printed circuit board on at least one side.

A connection pad of the plurality of connection pads may have a larger area than other connection pads of the plurality of connection pads, wherein the connection pad is adjacent to the connector, and a first pad of the plurality of first pads may have a larger area than other first pads of the plurality of first pads, wherein the first pad is adjacent to the connector.

At least one of the connection pad adjacent to the connector and the first pad adjacent to the connector may have a recessed portion recessed in a width direction of the second printed circuit board or the first printed circuit board on at least one side.

The second printed circuit board may have a hole recessed inwardly in a width direction of the second printed circuit board on one side, and the integrated module may include a protrusion protruding from the first surface and accommodated in the hole.

The hole may be one of a plurality of holes, and the protrusion may be one of a plurality of protrusions, and the plurality of holes and the plurality of protrusions may be placed on one side of the second printed circuit board and the first printed circuit board, respectively.

The hole may be one of a plurality of holes, and the protrusion may be one of a plurality of protrusions, and the plurality of holes and the plurality of protrusions may be alternately placed on one side and the other side of the second printed circuit board and the first printed circuit board, respectively.

A rechargeable battery according to an embodiment of the present disclosure may include an electrode assembly including an electrode lead, a case accommodating the electrode assembly, and the above-described circuit board assembly electrically connected to the electrode lead.

According to the present disclosure, the volume of the circuit board assembly may be reduced.

Additionally, according to embodiments of the present disclosure, soldering strength at a weak portion of the circuit board assembly may be increased.

In addition, according to embodiments of the present disclosure, misalignment between one or more circuit boards of the circuit board assembly may be suppressed or reduced for reducing or preventing warping.

At least some of the above and other features of the invention are set out in the claims.

Effects that may be obtained from the present disclosure will not be limited to only the above described effects, and other effects which are not described herein will become apparent to those skilled in the art from the following description.

### BRIEF DESCRIPTION OF THE DRAWINGS

The accompanying drawings illustrate preferred embodiments of the present disclosure and, together with the foregoing disclosure, serve to provide further understanding of the present disclosure, but the present disclosure is not to be construed as being limited to the drawings.
FIG. 1 is a perspective view of a rechargeable battery including a circuit board assembly according to an embodiment of the present disclosure.
FIG. 2 is an exploded perspective view of the rechargeable battery of FIG. 1.
FIG. 3 is a perspective view of a circuit board assembly according to an embodiment of the present disclosure.
FIG. 4 illustrates the electrical connection relationship between an integrated module and a flexible printed circuit board according to an embodiment of the present disclosure.
FIG. 5 is a cross-sectional view along line V-V of FIG. 3 according to an embodiment of the present disclosure.
FIG. 6 illustrates a portion of a circuit board assembly according to an embodiment of the present disclosure.
FIG. 7 is a partial cross-sectional view of a circuit board assembly according to an embodiment of the present disclosure.
FIG. 8 is a cross-sectional view taken along line VIII-VIII of FIG. 3.
FIG. 9 is a bottom view of the circuit board assembly of FIG. 3.
FIG. 10 is a bottom view of a circuit board assembly according to an embodiment of the present disclosure.

### DETAILED DESCRIPTION

Hereinafter, embodiments of the present disclosure will be described in detail with reference to the accompanying drawings. The terms and words used in the specification and claims of the present disclosure are not to be construed in their ordinary or dictionary sense, but rather as meanings and concepts conforming to the technical sense of the present disclosure based on the principle that the inventor can be his own lexicographer to appropriately define the concepts of the terms to explain the present disclosure in the best manner. Accordingly, it is to be understood that the detailed description, which will be disclosed along with the accompanying drawings, is intended to describe some of the embodiments of the present invention and is not intended to represent all technical ideas, aspects, and features of the present disclosure. Therefore, it should be understood that there may be various equivalents and modifications which can replace or modify the embodiments described herein at the time of the application.

A person of ordinary skill in the art would appreciate, in view of the present disclosure in its entirety, that a feature of embodiments of the present disclosure may be combined or combined with one or more other features, partially or entirely, and may be technically interlocked and operated in various suitable ways, and an embodiment may be implemented independently of one or more other embodiments, or in conjunction with the one or more other embodiments in a suitable manner, unless expressly stated or implied otherwise.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification.

Stating that two objects of comparison are "the same" means that they are "substantially the same."

Therefore, substantially identical may include a deviation that is considered low in the art-for example, a deviation of less than 5%. Additionally, uniformity of a parameter in a certain region may mean uniformity in terms of an average.

Although terms of "first," "second," and the like are used to explain various components, elements, regions, layers, and/or sections, the components, elements, regions, layers, and/or sections are not limited to such terms. These terms are only used to distinguish one component, element, region, layer, and/or section from another component, element, region, layer, and/or section, and unless explicitly stated to the contrary, the second component, element, region, layer, and/or section may be referred to as the first component, element, region, layer, and/or section.

Throughout the specification, unless otherwise stated, each component may be singular or plural.

It should also be understood that when a first element or layer is referred to as being "on" or "beneath" a second element or layer, the first element may be disposed directly on or beneath the second element or may be disposed indirectly on or beneath the second element with a third element or layer being disposed between the first and second elements or layers.

It should be noted that if it is stated in the specification that one component is "connected," or "coupled" to another component, a third component may be "connected," "coupled," and "joined" between the first and second components, although the first component may be directly connected, coupled, or joined to the second component. In addition, when a part is electrically coupled to another part, it includes not only cases where the two parts are directly connected, but also cases where they are connected with another element therebetween.

Reference to "A and/or B" throughout the specification, means A, B, or A and B, unless specifically stated to the contrary. That is, "and/or" includes all or any combination of the plurality of listed items. Reference to "C to D" means that it is greater than or equal to C and less than or equal to D, unless otherwise specified.

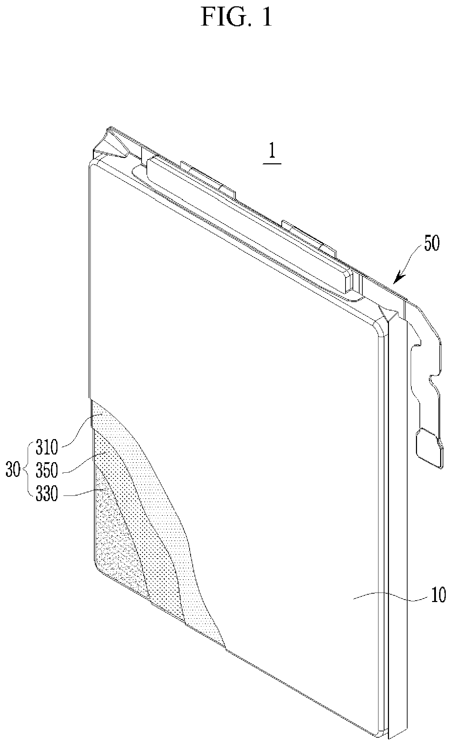

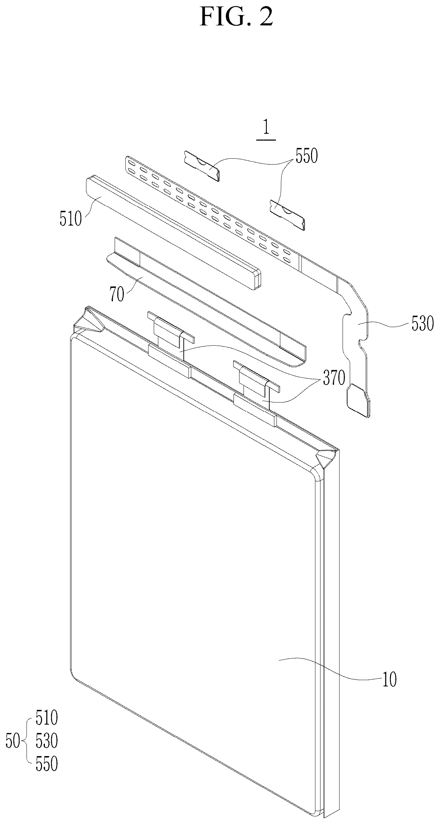

FIG. 1 is a perspective view of a rechargeable battery 1 including a circuit board assembly 50 according to an embodiment of the present disclosure. FIG. 2 is an exploded perspective view of the rechargeable battery 1 of FIG. 1. Referring to FIG. 1, the rechargeable battery 1 includes a case 10, an electrode assembly 30 accommodated in the case 10, and a circuit board assembly 50 electrically connected to the electrode assembly 30.

In the present embodiment, the case 10 is made of a pouch type formed of laminate film or plastic. Alternatively, the case 10 may be formed of a metal can (e.g., cylindrical or square).

The electrode assembly 30 may include a first electrode 310, a second electrode 330, and a separator 350 interposed therebetween. The first electrode 310 and the second electrode 330 may be electrodes having different polarities. For example, if the first electrode 310 is a positive electrode, the second electrode 330 may be a negative electrode, and vice versa.

The electrode assembly 30 includes the first electrode 310 and the second electrode 330 stacked with the separator 350 in between, and may be either a stacked type where such stacks are repeatedly stacked, or a wound type where the first electrode 310 positioned on one surface of the separator 350 and the second electrode 330 positioned on the other surface of the separator 350 are wound while maintaining their stacked state.

Referring to FIG. 2, the electrode assembly 30 may further include an electrode lead 370. The electrode lead 370 may be configured to be an extension of the substrate of each electrode 310 and 330 to which an active material layer is not applied. The electrode assembly 30 may be electrically connected to an external component via the electrode lead 370. The circuit board assembly 50 may be connected to the electrode lead 370.

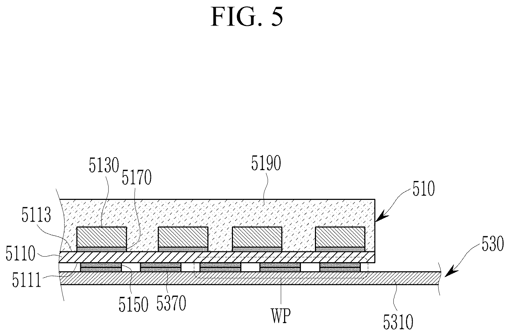

The circuit board assembly 50 may include an integrated (e.g., a first) module 510 and a flexible (e.g., second) printed circuit board 530. The integrated module 510 may be a system in package (SIP) module in which a plurality of electronic components are mounted on a circuit board. A detailed description of the integrated module 510 will be described later with reference to FIG. 5.

The integrated module 510 may be disposed or placed on one surface of the flexible printed circuit board 530. Additionally, a tab 550 made of a conductive material such as nickel may be disposed or placed on the other surface of the flexible printed circuit board 530. The tab 550 may be a component used to electrically connect the circuit board assembly 50 to the electrode lead 370.

However, the electrical connection between the electrode lead 370 and the circuit board assembly 50 is not limited to an indirect method using the tab 550, but may also be made by a direct method such as welding.

The rechargeable battery 1 may further include an insulating member 70 disposed or placed between the circuit board assembly 50 and the case 10. The insulating member 70 may have a structure in which two faces are connected at right angles. In some embodiments, the insulating member 70 is formed of an insulating material and may prevent unintended electrical connection between the electrode assembly 30 and the circuit board assembly 50.

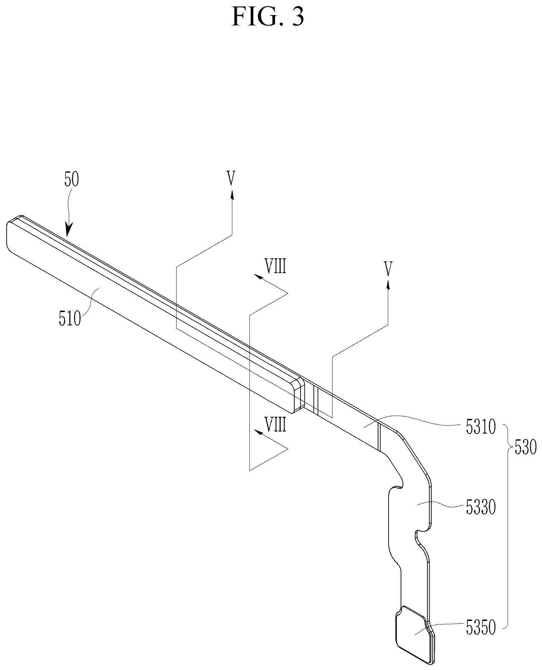

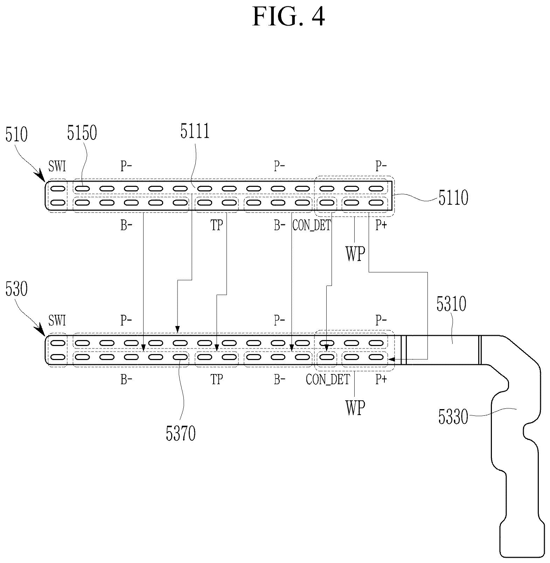

The circuit board assembly 50 electrically connected to the electrode assembly 30 may transmit information of the electrode assembly 30 to an external device, or transmit an external signal to the electrode assembly 30. The circuit board assembly 50 will be described in detail with reference to FIGS. 3 and 4.

FIG. 3 is a perspective view of the circuit board assembly 50 according to an embodiment of the present disclosure, and FIG. 4 illustrates the electrical connection relationship between the integrated module 510 and the flexible printed circuit board 530 of the circuit board assembly 50 of FIG. 3.

Referring to FIG. 3, the flexible printed circuit board 530 may include a main line portion 5310 and a connector 5330 extending from one side of the main line portion 5310. The integrated module 510 may be disposed or placed on the main line portion 5310, and a terminal 5350 for connection to an external component may be disposed or placed on one end of the connector 5330 that is not connected to the main line portion 5310.

The integrated module 510 disposed or placed on one surface of the main line portion 5310 may be electrically connected to the flexible printed circuit board 530. For example, the electrical connection may be soldering.

Referring to FIG. 4, a bottom view of the integrated module 510 and a top plan view of the flexible printed circuit board 530 are illustrated to describe the electrical connection relationship between the integrated module 510 and the flexible printed circuit board 530.

The flexible printed circuit board 530 may include one or more connection pads 5370 disposed or placed on one surface of the main line portion 5310. The one or more connection pads 5370 may be configured to electrically connect the flexible printed circuit board 530 to another component. In an embodiment, the one or more connection pads 5370 may be pads on which soldering takes place.

In some embodiments, the integrated module 510 including a printed circuit board (PCB, 5110) (e.g., first circuit board) may also include one or more first pads 5150 disposed or placed on a surface (hereinafter referred to as a first surface for convenience, 5111) of the printed circuit board 5110 that contacts the flexible printed circuit board 530.

The connection pad 5370 and the first pad 5150 may be arranged (e.g., identically arranged) to correspond to each other. For example, the arrangement of the connection pads 5370 may be similar or identical to the arrangement of the first pads 5150. For example, the one or more connection pads 5370 may be arranged in two rows.

The first row (upper row in FIG. 4) may have pads positioned for respectively soldering the negative electrode among the external connection terminals and the SWI (Switch input) terminal, and the second row (lower row in FIG. 4) may have pads positioned for soldering the positive electrode among the external connection terminals and the internal connection terminal, the SWI terminal, the TP (Test point) terminal, and the CON_DET (Connector detect) terminal. As described above, the one or more first pads 5150 may also have the same arrangement form.

The integrated module 510 and the flexible printed circuit board 530 may be electrically connected through soldering. In some embodiments, the flexible printed circuit board 530 receives the first surface 5111 of the printed circuit board 5110, substantially covering the first pads 5150 arranged on the first surface 5111. For example, the integrated module 510 and the flexible printed circuit board 530 may be electrically connected by surface mounting technology (SMT).

The surface mounting technology may enable the electrical connection between the printed circuit board 5110 and the integrated module 510 without user intervention by placing the integrated module 510 on the connection pad 5370 already disposed or placed on the flexible printed circuit board 530, melting the connection pad 5370 at high temperature, and then solidifying it at room temperature.

In general, in order to solder, the user must have an open upper space for soldering. However, in the case of surface mounting technology, the upper space may not need to be open, allowing modules or electronic components to be additionally disposed or placed in the upper space to reduce the volume of the completed circuit board and efficiently use the space of the electronic device in which the circuit board is used.

In some embodiments, while the first surface 5111 of printed circuit board 5110 is positioned on one surface of the flexible printed circuit board 530, the integrated module 510 can be soldered to one surface of the flexible printed circuit board 530 through surface mount technology.

Therefore, unlike a general circuit board assembly in which a flexible printed circuit board is connected on one side of a module, the circuit board assembly 50 according to an embodiment of the present disclosure may have a reduced volume.

FIG. 5 is a cross-sectional view along line V-V of FIG. 3. Referring to FIG. 5, the integrated module 510 may include the printed circuit board 5110, an electronic component 5130 mounted on the printed circuit board 5110, and a protective layer 5190 molded on the electronic component 5130.

The electronic component 5130 may be disposed or placed on one surface of the printed circuit board 5110, and one or more second pads 5170 may be disposed or placed on a second surface 5113 of the printed circuit board 5110 opposing the first surface 5111 for electrical connection between the electronic component 5130 and the printed circuit board 5110.

In some embodiments, surface mounting technology may be used for the electrical connection between the printed circuit board 5110 and the electronic component 5130 to allow mounting of more or additional number of electronic components 5130 on the printed circuit board 5110.

In some embodiments, soldering may be performed by placing the electronic component 5130 on the one or more second pads 5170 disposed or placed on the second surface 5113 and melting and solidifying the second pads 5170 by changing the temperature.

Accordingly, the integrated module 510 may use the space of the printed circuit board 5110 more efficiently and may mount more electronic components 5130 on the printed circuit board 5110 than in the general case that does not use surface mounting technology for mounting the electronic components. That is, surface mounting technology may be performed twice. In some embodiments, the temperatures at which each surface mounting technology is performed are different to prevent the solder pads that have already been soldered from melting again.

In some embodiments, the integrated module 510 may include the protective layer 5190 to avoid or lessen the damage of the electrical connection between the above components. The protective layer 5190 formed into a certain shape by using a molding compound may be disposed or placed on the electronic component 5130 while the electronic component 5130 is electrically connected to the printed circuit board 5110. In this case, the molding compound may have high mechanical strength and excellent electrical insulating characteristics and may be epoxy-based.

While the integrated module 510 and the flexible printed circuit board 530 are electrically connected, the connector 5330 of the flexible printed circuit board 530 may not be connected to the integrated module 510. According to this embodiment, when an external force is applied to the connector 5330, there is a high possibility that the soldering will be damaged in a portion WP positioned close to the connector 5330 (hereinafter referred to as a weak portion for convenience).

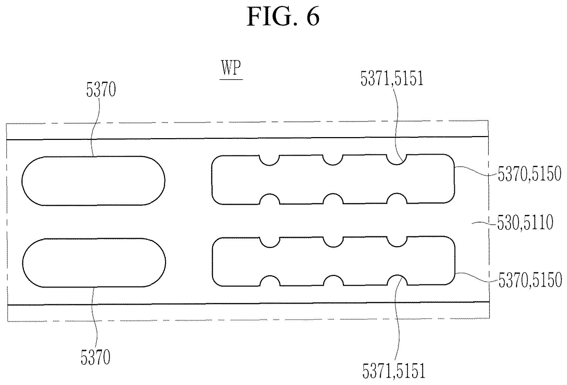

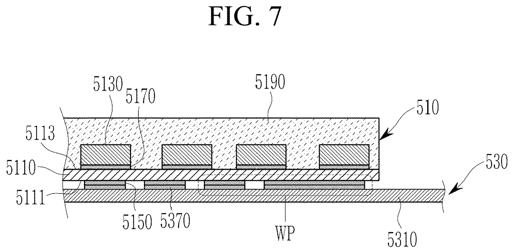

FIG. 6 illustrates the weak portion WP of a circuit board assembly 50 according to an embodiment of the present disclosure, and FIG. 7 is a partial cross-sectional view of a circuit board assembly 50 according to an embodiment of the present disclosure. FIG. 6 may illustrate either the printed circuit board 5110 or the flexible printed circuit board 530 of the circuit board assembly 50.

Referring to FIGS. 6 and 7, the circuit board assembly 50 according to an embodiment of the present disclosure may expand the area of pads 5150 and 5370 positioned at the weak portion WP to prevent damage at the weak portion WP. In some embodiments, the circuit board assembly 50 may expand the area by merging the pads 5150 and 5370 for soldering with adjacent terminals of the same type.

For example, the area may be expanded by merging the connection pads 5370 of the flexible printed circuit board 530 in the weak portion WP. In some embodiments, when merging connection pads 5370, the connection pads 5370 may be merged for soldering the same type of terminal.

For example, referring to FIG. 4, two connection pads 5370 for connecting the positive electrodes of the external connection terminals are disposed or placed on the weak portion WP of the flexible printed circuit board 530, and the connection pad 5370 for soldering the CON_DET terminal is disposed or placed on one side of the weak portion WP.

Therefore, in this case, the area may be expanded by merging two (e.g., only two) connection pads 5370 for connecting the positive electrodes among the external connection terminals.

The circuit board assembly 50 according to one embodiment of the present disclosure may have a recessed portion 5371 that is recessed in the width direction (up-down direction in FIG. 6) of the flexible printed circuit board 530 on at least one side of the connection pads 5370 to prevent further occurrence of misalignment between the flexible printed circuit board 530 and the integrated module 510 during soldering as the area of the connection pads 5370 increases.

The recessed portion 5371 may properly align the soldering position of each component by allowing the molten connection pad 5370 to be concentrated toward the center during soldering. There may be one or more recessed portions 5371.

In addition, similarly, the first pads 5150 of the printed circuit board 5110 in the weak portion WP may also be merged and may have at least one recessed portion 5151 that is recessed in the width direction (up-down direction in FIG. 6) of the printed circuit board 5110.

In some embodiments, both the connection pad 5370 and the first pad 5150 may have an enlarged area and at least one recessed portion 5371 and 5151.

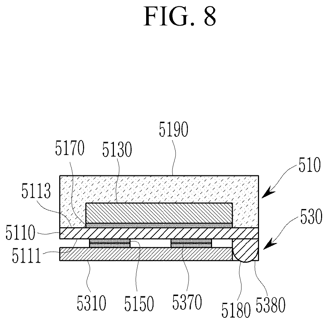

FIG. 8 is a cross-sectional view taken along line VIII-VIII of FIG. 3. Referring to FIG. 8, the flexible printed circuit board 530 may have a hole 5380 that is recessed inwardly based on the width direction of the flexible printed circuit board 530 on one side, and the printed circuit board 5110 of the integrated module 510 may have a protrusion 5180 protruding from the first surface 5111 and accommodated in the hole 5380.

The circuit board assembly 50 may prevent or lessen misalignment between the integrated module 510 and the flexible printed circuit board 530 that may occur in the SMT process in which soldering is performed without human intervention through the hole 5380 and the protrusion 5180 accommodated therein. Preventing or lessening the misalignment may prevent or diminish the chance of the circuit board assembly 50 increasing in volume.

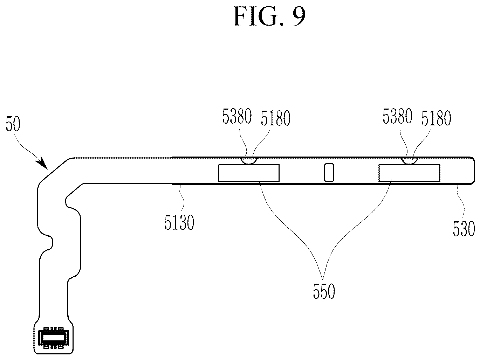

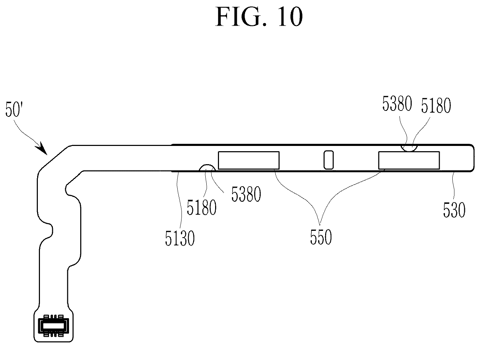

FIG. 9 is a bottom view of the circuit board assembly 50 of FIG. 3, and FIG. 10 is a bottom view of the circuit board assembly 50 according to an embodiment of the present disclosure.

Referring to FIG. 9, the circuit board assembly 50 may have one or more holes 5380 and one or more protrusions 5180 accommodated therein. In some embodiments, the shape of the hole 5380 may be a semicircle, but is not limited thereto. When there are one or more holes 5380 and protrusions 5180, the holes 5380 and protrusions 5180 may be aligned on one side of the flexible printed circuit board 530 and the printed circuit board 5110, respectively.

Referring to FIG. 10, the circuit board assembly 50 according to one embodiment of the present disclosure has one or more holes 5380 and protrusions 5180, which may be alternately disposed or placed on one side and the other side of the flexible printed circuit board 530 and the printed circuit board 5110, respectively. In some embodiments, the effect of preventing distortion may be superior compared to the embodiment where the holes and protrusions are aligned on one side.

While the embodiments of the present disclosure have been described in detail, it is to be understood that the disclosure is not limited to the disclosed embodiments, but on the contrary, is intended to cover various modifications and equivalent arrangements included within the scope of the appended claims.

### Description of symbols

| | | | |
|---|---|---|---|
| 1: | Rechargeable battery | 10: | Case |
| 30: | Electrode assembly | 50: | Circuit board assembly |
| 70: | Insulating member | 310: | First electrode |
| 330: | Second electrode | 350: | Separator |
| 370: | Electrode lead | 510: | Integrated module |
| 530: | Flexible printed circuit board | 550: | Tab |
| 5110: | Printed circuit board | 5111: | First surface |
| 5113: | Second surface | 5130: | Electronic component |
| 5150: | First pad | 5151: | Recessed portion |
| 5170: | Second pad | 5180: | Protrusion |
| 5190: | Protective layer | 5310: | Main line portion |
| 5330: | Connector | 5350: | Terminal |
| 5370: | Connection pad | 5371: | Recessed portion |
| 5380: | Hole | WP: | Weak portion |

## Claims

1. A circuit board assembly, comprising:
an integrated module comprising a first printed circuit board having a first surface and a second surface opposite to the first surface, a plurality of first pads on the first surface, and a plurality of electronic components on the second surface; and
a second printed circuit board comprising a main line portion, the second printed circuit board receiving the first surface of the first printed circuit board and covering the plurality of first pads, and a connector extending from one side of the main line portion,
wherein the first printed circuit board and the second printed circuit board are electrically connected.

2. The circuit board assembly as claimed in claim 1, wherein
the second printed circuit board further comprises a plurality of connection pads on one surface of the main line portion and arranged corresponding to the arrangement of the first pads.

3. The circuit board assembly as claimed in claim 2, wherein
a connection pad of the plurality of connection pads has a larger area than other connection pads of the plurality of connection pads, wherein the connection pad is adjacent to the connector.

4. The circuit board assembly as claimed in claim 3, wherein
the connection pad adjacent to the connector has a recessed portion recessed in a width direction of the second printed circuit board on at least one side.

5. The circuit board assembly as claimed in claim 2, 3 or 4, wherein
a first pad of the plurality of first pads has a larger area than other first pads of the plurality of first pads, wherein the first pad is adjacent to the connector.

6. The circuit board assembly as claimed in claim 5, wherein
the first pad adjacent to the connector has a recessed portion recessed in a width direction of the first printed circuit board on at least one side.

7. The circuit board assembly as claimed in claim 2, wherein
a connection pad of the plurality of connection pads has a larger area than other connection pads of the plurality of connection pads, wherein the connection pad is adjacent to the connector, and
a first pad of the plurality of first pads has a larger area than other first pads of the plurality of first pads, wherein the first pad is adjacent to the connector.

8. The circuit board assembly as claimed in claim 7, wherein
at least one of the connection pad adjacent to the connector and the first pad adjacent to the connector has a recessed portion recessed in a width direction of the second printed circuit board or the first printed circuit board on at least one side.

9. The circuit board assembly as claimed in any preceding claim, wherein
the second printed circuit board has a hole recessed inwardly in a width direction of the second printed circuit board on one side, and
the integrated module comprises a protrusion protruding from the first surface and accommodated in the hole.

10. The circuit board assembly as claimed in claim 9, wherein
the hole is one of a plurality of holes, and the protrusion is one of a plurality of protrusions, and
the plurality of holes and the plurality of protrusions are placed on one side of the second printed circuit board and the first printed circuit board, respectively.

11. The circuit board assembly as claimed in claim 9, wherein
the hole is one of a plurality of holes, and the protrusion is one of a plurality of protrusions, and
the plurality of holes and the plurality of protrusions are alternately placed on one side and the other side of the second printed circuit board and the first printed circuit board, respectively.

12. A rechargeable battery, comprising:
an electrode assembly comprising an electrode lead;
a case accommodating the electrode assembly; and
the circuit board assembly as claimed in any preceding claim electrically connected to the electrode lead.
